(19) Europäisches Patentamt
European Patent Office
Office européen des brevets

(11) EP 3 795 713 A1

(12) **EUROPEAN PATENT APPLICATION**
published in accordance with Art. 153(4) EPC

(43) Date of publication:
**24.03.2021 Bulletin 2021/12**

(21) Application number: **19803357.3**

(22) Date of filing: **17.05.2019**

(51) Int Cl.:
***C23C 14/34** (2006.01)*
***B32B 15/01** (2006.01)*
***C22C 5/06** (2006.01)*
***C23C 14/06** (2006.01)*
***C23C 14/08** (2006.01)*
***C23C 14/14** (2006.01)*
***H01B 5/14** (2006.01)*

(86) International application number:
**PCT/JP2019/019612**

(87) International publication number:
**WO 2019/221257 (21.11.2019 Gazette 2019/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.05.2018 JP 2018095293**
**13.05.2019 JP 2019090548**

(71) Applicant: **Mitsubishi Materials Corporation**
**Tokyo 100-8117 (JP)**

(72) Inventors:
- **TOSHIMORI Yuto**
**Naka-shi, Ibaraki 311-0102 (JP)**
- **NONAKA Sohei**
**Naka-shi, Ibaraki 311-0102 (JP)**

(74) Representative: **Hoffmann Eitle**
**Patent- und Rechtsanwälte PartmbB**
**Arabellastraße 30**
**81925 München (DE)**

(54) **MULTILAYER FILM AND AG ALLOY SPUTTERING TARGET**

(57) What is provided is a lamination film 10 including an Ag alloy film 11 and a transparent conductive oxide film 12 laminated on one or both surfaces of the Ag alloy film 11, in which the Ag alloy film 11 contains Ge in a range of 5.0 atom% to 13.0 atom% and a balance of Ag and inevitable impurities, and the Ag alloy film 11 has a film thickness in a range of 3 nm to 10 nm.

FIG. 1

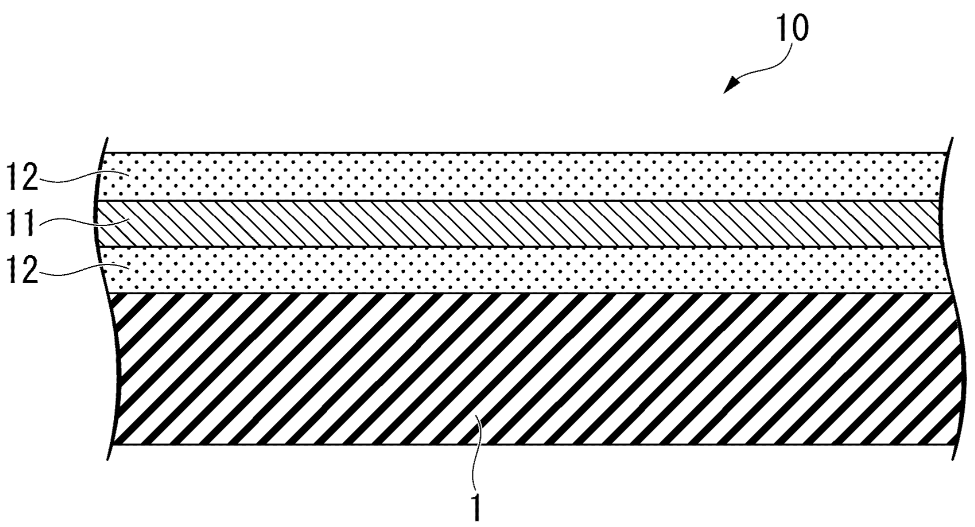


EP 3 795 713 A1

**Description**

TECHNICAL FIELD

The present invention relates to a lamination film which can be used, for example, as a transparent conductive wiring film or a transparent electrode of a display or a touch panel, and an Ag alloy sputtering target used in a case of forming an Ag alloy film constituting the lamination film.

Priority is claimed on Japanese Patent Application No. 2018-095293, filed May 17, 2018 and No. 2019-090548, filed May 13, 2019, the content of which is incorporated herein by reference.

BACKGROUND ART

For example, in a liquid crystal display, an organic EL display, a touch panel, and the like, for example, a lamination film having a laminated structure of a transparent conductive oxide film and an Ag film containing Ag or an Ag alloy is used as a wiring, as disclosed in Patent Documents 1-3. This lamination film is necessary to have a high transmittance of light in a visible light region and a low electrical resistance.

In addition, in a case of forming an Ag film containing Ag or an Ag alloy on a glass substrate or the like, for example, a sputtering method using a sputtering target containing Ag or an Ag alloy is widely used as disclosed in Patent Document 4.

[Citation List]

[Patent Literature]

[Patent Document 1]
Japanese Unexamined Patent Application, First Publication No. H09-291356
[Patent Document 2]
Japanese Unexamined Patent Application, First Publication No. H10-239697
[Patent Document 3]
Japanese Unexamined Patent Application, First Publication No. 2016-040411
[Patent Document 4]
Japanese Unexamined Patent Application, First Publication No. 2016-164305

SUMMARY OF INVENTION

Technical Problem

In recent years, in a display, a touch panel, and the like, a wiring and an electrode have been further miniaturized, and lengths of the wiring and the electrode have become longer due to an increase in screen size. As a transparent conductive wiring film or a transparent electrode, it is necessary to provide a lamination film having lower electrical resistance and more excellent transmittance of visible light region than those in the related art. In other words, this lamination film is required to have excellent electrical characteristics and optical characteristics.

Here, in a lamination film having a laminated structure of a transparent conductive oxide film and an Ag film containing Ag or Ag alloy, it is necessary to reduce a film thickness of the Ag film containing Ag or Ag alloy, in order to further improve the transmittance.

However, in a case where the thickness of the Ag film is simply reduced, Ag easily aggregates. Accordingly, the Ag film may become a discontinuous film and the electrical resistance may increase. In addition, the transmittance may be significantly reduced due to the Ag aggregation.

In particular, in a case where the film thickness is 10 nm or less, Ag is likely to be aggregated and the Ag film is likely to be a discontinuous film. Accordingly, it was difficult to obtain a lamination film having excellent electrical characteristics and optical characteristics.

In addition, during mass production, film formation may be performed in a state where a film forming apparatus contains residual gas (water vapor or the like). In a case where the Ag film is formed in an atmosphere containing water vapor, the water vapor may promote the aggregation of Ag on a surface of the Ag film, which may make it difficult to form the Ag film stably.

The present invention has been made in view of the above-mentioned circumstances, and an object thereof is to provide, for example, a lamination film including an Ag alloy film having a thin film thickness of 10 nm or less, having excellent electrical characteristics and optical characteristics, and particularly suitable for a transparent conductive wiring film or a transparent electrode, and a Ag alloy sputtering target used in a case of forming an Ag alloy film configuring the lamination film.

Solution to Problem

In order to solve the above problems, there is provided a lamination film of one embodiment of the present invention (hereinafter referred to as "a lamination film of the present invention") including: a lamination film including an Ag alloy film and a transparent conductive oxide film laminated on one or both surfaces of the Ag alloy film, in which the Ag alloy film contains Ge in a range of 5.0 atom% to 13.0 atom% and a balance of Ag and inevitable impurities, and the Ag alloy film has a film thickness in a range of 3 nm to 10 nm.

According to the lamination film of the present invention, the Ag alloy film contains Ge in a range of 5.0 atom% to 13.0 atom% and the balance of Ag and inevitable impurities. Accordingly, diffusion of Ag is suppressed by Ge, and even in a case where the Ag alloy film is formed to be thin with the film thickness of 3 nm to 10 nm, it is possible to suppress the aggregation of Ag and prevent the Ag alloy film from becoming a discontinuous film. Even in a case where the film is formed in an atmosphere containing water vapor, it is possible to suppress the Ag aggregation on a surface of the Ag film, and even in a case where the film is formed by a mass production apparatus having poor exhaust capability, it is possible to prevent the Ag alloy film from becoming a discontinuous film.

In addition, the film thickness of the Ag alloy film is 3 nm or more. Accordingly, the electrical characteristics can be ensured. Furthermore, the film thickness of the Ag alloy film is 10 nm or less. Accordingly, the optical characteristics can be ensured.

Therefore, it is possible to provide a lamination film having excellent electrical characteristics and optical characteristics and particularly suitable for a transparent conductive wiring film or a transparent electrode.

In the lamination film of the present invention, the Ag alloy film may further contain any one or two or more of elements selected from the group consisting of In, Zn, and Sn, and an atomic ratio (In + Zn + Sn)/(Ge) of a total amount (In + Zn + Sn) of any one or two or more selected from the group consisting of In, Zn, and Sn to an amount (Ge) of Ge may be in a range of 0.05 to 0.50.

In this case, the Ag alloy film contains In, Zn, and Sn which are elements having an effect of suppressing the diffusion movement of Ag atoms, in the same manner as Ge, and the atomic ratio ((In + Zn + Sn)/(Ge) of the total amount (In + Zn + Sn) of In, Zn, and Sn to the amount (Ge) of Ge is 0.05 or more. Accordingly, even in a case where the Ag alloy film is formed thin to have a film thickness of 3 nm to 10 nm, it is possible to suppress the Ag aggregation and prevent the Ag alloy film from becoming a discontinuous film.

In addition, the atomic ratio (In + Zn + Sn)/(Ge) of the Ag alloy film is limited to 0.50 or less. Accordingly, it is possible to prevent a deterioration in environment resistance and water vapor resistance due to In, Zn, and Sn.

In the lamination film of the present invention, the Ag alloy film may further contain any one or two or more elements selected from the group consisting of Pd, Au, and Pt, an atomic ratio (Pd + Au + Pt)/(Ge) of a total amount (Pd + Au + Pt) of any one or two or more elements selected from the group consisting of Pd, Au, and Pt to an amount (Ge) of Ge may be 0.01 or more, and an atomic ratio (In + Zn + Sn + Pd + Au + Pt)/(Ge) of a total amount (In + Zn + Sn + Pd + Au + Pt) of any one or two or more elements selected from the group consisting of In, Zn, Sn, Pd, Au, and Pt to the amount (Ge) of Ge may be 0.50 or less.

In this case, the Ag alloy film contains Pd, Au, and Pt which are elements having an effect of improving environment resistance, and the atomic ratio (Pd + Au + Pt)/(Ge) of the total amount (Pd + Au + Pt) of any one or two or more elements selected from the group consisting of Pd, Au, and Pt to the amount (Ge) of Ge is 0.01 or more. Accordingly, it is possible to sufficiently improve environment resistance of the Ag alloy film.

In the Ag alloy film, the atomic ratio (In + Zn + Sn + Pd + Au + Pt)/(Ge) of the total amount (In + Zn + Sn + Pd + Au + Pt) of any one or two or more elements selected from the group consisting of In, Zn, Sn, Pd, Au, and Pt to the amount (Ge) of Ge is limited to 0.50 or less. Accordingly, it is possible to prevent a deterioration in water vapor resistance caused by Pd, Au, and Pt.

In the lamination film of the present invention, it is preferable that a sheet resistance of the lamination film is set to 40 Ω/□ (Ω/sq.) or less, and a distribution $D_R = (\sigma_R/\mu_R) \times 100$ of the sheet resistance defined by an average value $\mu_R$ and a standard deviation $\sigma_R$ of the sheet resistance measured at a plurality of in-plane points is 20% or less.

In this case, the sheet resistance of the lamination film is set to 40Ω/□ or less. Accordingly, the electrical characteristics are sufficiently excellent. In addition, the distribution $D_R$ of the sheet resistance described above is 20% or less. Accordingly, properties such as the sheet resistance and the like are stable in the plane of the lamination film. That is, even in a case where the Ag alloy film is formed thin to have a film thickness of 3 nm to 10 nm, the Ag alloy film having a comparatively uniform film thickness is formed.

In the lamination film of the present invention, the transparent conductive oxide film may include any one or two or more selected from the group consisting of an In oxide, a Sn oxide, a Zn oxide, a Nb oxide, a Ti oxide, an Al oxide, and a Ga oxide.

In this case, the transparent conductive oxide film laminated on the Ag alloy film includes any one or two or more selected from the group consisting of an In oxide, a Sn oxide, a Zn oxide, a Nb oxide, a Ti oxide, an Al oxide, and a Ga oxide. Accordingly, the electrical characteristics and optical characteristics of the transparent conductive oxide film are excellent and it is possible to improve the electrical characteristics and optical characteristics of the entire lamination film.

In the lamination film of the present invention, the transparent conductive oxide film may have a refractive index in a range of 1.9 to 2.4 at a wavelength of 550 nm and have a film thickness in a range of 5 nm to 50 nm.

In this case, the transparent conductive oxide film laminated on the Ag alloy film has a refractive index in a range of 1.9 to 2.4 at a wavelength of 550 nm and has a film thickness in a range of 5 nm to 50 nm. Accordingly, it is possible to improve visible light transmittance of the transparent conductive oxide film and sufficiently improve the visible light transmittance of the entire lamination film.

There is provided an Ag alloy sputtering target of the present invention containing Ge in a range of 5.0 atom% to 13.0 atom% and a balance of Ag and inevitable impurities, in which an average value of crystal grain sizes is 200 μm or less, and a distribution, $D_{GS} = (\sigma_{GS}/(\mu_{GS}) \times 100$, of the crystal grain sizes defined by an average value $\mu_{GS}$ of the crystal grain sizes and a standard deviation $\sigma_{GS}$ of the crystal grain sizes measured at a plurality of points of a target surface is 25% or less.

The Ag alloy sputtering target having this configuration contains Ge in a range of 5.0 atom% to 13.0 atom% and the balance of Ag and inevitable impurities. Accordingly, the Ag diffusion is suppressed by Ge in the formed Ag alloy film, and even in a case where the Ag alloy film is formed thin to have a film thickness of 3 nm to 10 nm, it is possible to suppress the Ag aggregation and form an Ag alloy film having a comparatively uniform film thickness.

In addition, the average value of the crystal grain sizes is 200 μm or less and the distribution $D_{GS} = (\sigma_{GS}/(\mu_{GS}) \times 100$ of the crystal grain sizes defined by the average value $\mu_{GS}$ of the crystal grain sizes and the standard deviation $\sigma_{GS}$ of the crystal grain sizes measured at a plurality of points of a target surface is 25% or less. Accordingly, a sputtering rate is comparatively constant over the entire target surface and it is possible to stably form the Ag alloy film having a film thickness of 3 nm to 10 nm.

In the Ag alloy sputtering target of the present invention, the Ag alloy sputtering target may further contain any one or two or more of elements selected from the group consisting of In, Zn, and Sn, and an atomic ratio (In + Zn + Sn)/(Ge) of a total amount (In + Zn + Sn) of any one or two or more selected from the group consisting of In, Zn, and Sn to an amount (Ge) of Ge may be in a range of 0.05 to 0.50.

In this case, the atomic ratio (In + Zn + Sn)/(Ge) of the total amount (In + Zn + Sn) of any one or two or more elements selected from the group consisting of In, Zn, and Sn to the amount (Ge) of Ge is set to 0.05 or more. Accordingly, even in a case of the thin Ag alloy film having a film thickness of 3 nm to 10 nm, it is possible to suppress the Ag aggregation and stably form the Ag alloy film.

In addition, the atomic ratio (In+Zn+Sn)/(Ge) is limited to 0.50 or less. Accordingly, it is possible to prevent a deterioration in environment resistance and water vapor resistance due to In, Zn, and Sn and prevent the Ag aggregation, even in a case where the film is formed in an atmosphere containing water vapor.

In the Ag alloy sputtering target of the present invention, the Ag alloy sputtering target may further contain any one or two or more elements selected from the group consisting of Pd, Au, and Pt, an atomic ratio (Pd + Au + Pt)/(Ge) of a total amount (Pd + Au + Pt) of any one or two or more elements selected from the group consisting of Pd, Au, and Pt to an amount (Ge) of Ge may be 0.01 or more, and an atomic ratio (In + Zn + Sn + Pd + Au + Pt)/(Ge) of a total amount (In + Zn + Sn + Pd + Au + Pt) of any one or two or more elements selected from the group consisting of In, Zn, Sn, Pd, Au, and Pt to the amount (Ge) of Ge may be 0.50 or less.

In this case, the atomic ratio (Pd + Au + Pt)/(Ge) of the total amount (Pd + Au + Pt) of any one or two or more elements selected from the group consisting of Pd, Au, and Pt to the amount (Ge) of Ge is 0.01 or more. Accordingly, it is possible to form the Ag alloy film having excellent environment resistance.

In addition, the atomic ratio (In + Zn + Sn + Pd + Au + Pt)/(Ge) of the total amount (In + Zn + Sn + Pd + Au + Pt) of any one or two or more elements selected from the group consisting of In, Zn, Sn, Pd, Au, and Pt to the amount (Ge) of Ge is limited to 0.50 or less. Accordingly, it is possible to prevent a deterioration in water vapor resistance caused by Pd, Au, and Pt, and even in a case where the film is formed in an atmosphere containing water vapor, it is possible to suppress the Ag aggregation.

## Advantageous Effects of Invention

According to the present invention, it is possible to provide a lamination film including an Ag alloy film having a thin film thickness of 10 nm or less, having excellent electrical characteristics and optical characteristics, and particularly suitable for a transparent conductive wiring film or a transparent electrode, and a Ag alloy sputtering target used in a case of forming an Ag alloy film configuring the lamination film.

BRIEF DESCRIPTION OF DRAWINGS

Fig. 1 is a cross-sectional explanatory diagram of a lamination film according to an embodiment of the present invention.
Fig. 2A is an image showing a result of observing a distribution state of Ag in an Ag alloy film.
Fig. 2B is an image showing a result of observing a distribution state of Ge in an Ag alloy film.
Fig. 3 is an explanatory diagram showing measurement positions of sheet resistance in a plane of the lamination film according to the embodiment of the present invention.
Fig. 4 is an explanatory diagram showing measurement positions of crystal grain sizes on a target surface of an Ag alloy sputtering target according to the embodiment of the present invention.
Fig. 5 is a cross-sectional explanatory diagram of a lamination film according to another embodiment of the present invention.
Fig. 6 is a cross-sectional explanatory diagram of a lamination film according to another embodiment of the present invention.
Fig. 7 is a cross-sectional explanatory diagram of a lamination film according to another embodiment of the present invention.
Fig. 8 is an explanatory diagram showing measurement positions of crystal grain sizes on a target surface of a disc-type sputtering target.
Fig. 9A is an explanatory diagram showing measurement positions of crystal grain sizes as seen from a direction parallel to an axis on a target surface of a cylindrical sputtering target.
Fig. 9B is an explanatory diagram showing the measurement position of the crystal grain size as seen from a direction perpendicular to the axis on the target surface of the cylindrical sputtering target.

DESCRIPTION OF EMBODIMENTS

Hereinafter, a lamination film and an Ag alloy sputtering target according to one embodiment of the present invention will be described.

A lamination film 10 according to the embodiment is used as a transparent conductive wiring film or a transparent electrode of various displays and touch panels.

<Lamination Film>

As shown in Fig. 1, the lamination film 10 according to the embodiment includes an Ag alloy film 11 formed on one surface side of a substrate 1 containing glass or the like, and transparent conductive oxide films 12 formed on both surfaces of the Ag alloy film 11, respectively.

The Ag alloy film 11 contains Ge in a range of 5.0 atom% to 13.0 atom% and a balance of Ag and inevitable impurities.

The Ag alloy film 11 may further contain any one or two or more of elements selected from the group consisting of In, Zn, and Sn, and an atomic ratio (In + Zn + Sn)/(Ge) of a total amount (In + Zn + Sn) of any one or two or more selected from the group consisting of In, Zn, and Sn to an amount (Ge) of Ge may be in a range of 0.05 to 0.50.

In addition, the Ag alloy film 11 may further contain any one or two or more elements selected from the group consisting of Pd, Au, and Pt, an atomic ratio (Pd + Au + Pt)/(Ge) of a total amount (Pd + Au + Pt) of any one or two or more elements selected from the group consisting of Pd, Au, and Pt to the amount (Ge) of Ge may be 0.01 or more, and an atomic ratio (In + Zn + Sn + Pd + Au + Pt)/(Ge) of a total amount (In + Zn + Sn + Pd + Au + Pt) of any one or two or more elements selected from the group consisting of In, Zn, Sn, Pd, Au, and Pt to the amount (Ge) of Ge may be 0.50 or less.

The film thickness of the Ag alloy film 11 is in a range of 3 nm to 10 nm.

The transparent conductive oxide film 12 is formed of a transparent conductive oxide including any one or two or more selected from the group consisting of an In oxide, a Sn oxide, a Zn oxide, a Nb oxide, a Ti oxide, an Al oxide, and a Ga oxide. Specifically, examples thereof include an In-Sn oxide (ITO), an Al-Zn oxide (AZO), an In-Zn oxide (IZO), a Zn-Sn oxide (ZTO), a Zn-Sn-Al oxide (AZTO), a Ga-Zn oxide (GZO), a Zn-Y oxide (ZYO), a Ga-Zn-Y oxide (GZYO), and the like.

In addition, the film thickness of the transparent conductive oxide film 12 is preferably, for example, in a range of 5 nm to 50 nm. Further, the transparent conductive oxide film 12 preferably has a refractive index in a range of 1.9 to 2.4 at a wavelength of 550 nm.

In the lamination film 10 of the embodiment, the sheet resistance is 40Ω/□ or less.

In addition, a distribution $D_R = (\sigma_R/\mu_R) \times 100$ of the sheet resistance defined by an average value $\mu_R$ and a standard deviation $\sigma_R$ of the sheet resistance measured at a plurality of in-plane points of the lamination film 10 is 20% or less.

Further, in the lamination film 10 of the embodiment, an average transmittance at a wavelength of 380 nm to 780 nm is 85% or more.

Here, the reasons for setting the component compositions of the Ag alloy film 11, the sheet resistance and the average transmittance of the lamination film 10, and the refractive index and the film thickness of the transparent conductive oxide film 12 in the lamination film 10 of the embodiment as described above will be described.

(Ge)

Ge is segregated on a surface (interface) of the Ag alloy film 11, as shown in Figs. 2A and 2B, for example. This has the operation effect of suppressing diffusion movement of Ag atoms and suppressing aggregation of Ag in the Ag alloy film 11. In addition, since Ge suppresses the diffusion of the Ag element particularly on the surface of the Ag alloy film 11, the Ag aggregation is suppressed even in a case where the film is formed in the presence of water vapor. Figs. 2A and 2B show results of energy dispersive X-ray analysis (EDS) of Ge of the Ag alloy film 11 using a spherical aberration correction scanning transmission electron microscope (Cs-STEM), in which Fig. 2A shows distribution 11Ag of Ag and Fig. 2B shows a distribution 11Ge of Ge. From Figs. 2A and 2B, it is confirmed that Ge is segregated on the surface (interface) of the Ag alloy film 11.

Here, in a case where a content Ge is less than 5.0 atom%, the operation effects described above may not be achieved. On the other hand, in a case where the amount of Ge exceeds 13.0 atom%, it exceeds a solid solubility limit of Ge with respect to Ag. Accordingly, it is difficult to manufacture an Ag alloy sputtering target used for film formation.

Therefore, in the embodiment, the content Ge in the Ag alloy film 11 is set in a range of 5.0 atom% to 13.0 atom%.

In order to suppress the diffusion movement of Ag atoms to further suppress the Ag aggregation in the Ag alloy film 11, the amount of Ge in the Ag alloy film 11 is preferably 7.0 atom% or more and more preferably 9.0 atom% or more.

On the other hand, in order to more stably manufacture the Ag alloy sputtering target used for film formation, the amount of Ge in the Ag alloy film 11 is preferably 12.0 atom% or less and more preferably 11.0 atom% or less.

(Any one or two or more elements selected from the group consisting of In, Zn, and Sn)

The elements such as In, Zn, and Sn described above have the operation effect of suppressing the Ag aggregation in the Ag alloy film 11, in the same manner as Ge. Therefore, In, Zn, and Sn may be suitably added.

Here, by setting the atomic ratio (In + Zn + Sn)/(Ge) of the total amount (In + Zn + Sn) of any one or two or more selected from the group consisting of In, Zn, and Sn to the amount (Ge) of Ge to 0.05 or more, it is possible to sufficiently exhibit the operation effects described above by adding In, Zn, and Sn. On the other hand, by setting the atomic ratio (In + Zn + Sn)/(Ge) to 0.50 or less, it is possible to suppress a deterioration in water vapor resistance and environment resistance due to In, Zn, and Sn.

Therefore, in the embodiment, in a case where the Ag alloy film 11 contains any one or two or more elements selected from the group consisting of In, Zn, and Sn, the atomic ratio (In + Zn + Sn)/(Ge) is set in a range of 0.05 to 0.50.

In order to further suppress the Ag aggregation by In, Zn, and Sn, the atomic ratio (In + Zn + Sn)/(Ge) is preferably 0.10 or more and more preferably 0.15 or more.

On the other hand, in order to further suppress a deterioration in water vapor resistance and environment resistance due to In, Zn, and Sn, the atomic ratio (In + Zn + Sn)/(Ge) is preferably 0.40 or less and more preferably 0.30 or less.

In a case where any one or two or more elements selected from the group consisting of In, Zn, and Sn described above are contained as impurities, the atomic ratio (In + Zn + Sn)/(Ge) may be less than 0.05.

(Any One or Two or More Elements Selected From the Group Consisting of Pd, Au and Pt)

The elements such as Pd, Au, and Pt described above have the operation effect of improving the environment resistance (resistance to the hot and humid environment) of the Ag alloy film 11. Therefore, in a case where the environment resistance of the Ag alloy film 11 is required, it is preferable to add the elements appropriately.

Here, by setting the atomic ratio (Pd + Au + Pt)/(Ge) of the total amount (Pd + Au + Pt) of any one or two or more selected from the group consisting of Pd, Au, and Pt to the amount (Ge) of Ge to 0.01 or more, it is possible to sufficiently exhibit the operation effects described above by adding Pd, Au, and Pt. On the other hand, by setting the atomic ratio (In + Zn + Sn + Pd + Au + Pt)/(Ge) of the total amount (In + Zn + Sn + Pd + Au + Pt) of any one or two or more selected from the group consisting of In, Zn, Sn, Pd, Au, and Pt to the amount (Ge) of Ge to 0.50 or less, it is possible to suppress deterioration in water vapor resistance due to Pd, Au, and Pt.

Therefore, in the embodiment, in a case where the Ag alloy film 11 contains any one or two or more elements selected from the group consisting of Pd, Au and Pt, the atomic ratio (Pd + Au + Pt)/(Ge) is set to 0.01 or more and the atomic ratio (In + Zn + Sn + Pd + Au + Pt)/(Ge) is set to 0.50 or less.

In order to further improve the environment resistance (resistance to the hot and humid environment) of the Ag alloy film 11, the atomic ratio (Pd + Au + Pt)/(Ge) is preferably 0.02 or more and more preferably 0.05 or more.

On the other hand, in order to further suppress a deterioration in water vapor resistance due to Pd, Au and Pt, the atomic ratio (In + Zn + Sn + Pd + Au + Pt)/(Ge) is preferably 0.40 or less and more preferably 0.30 or less.

In addition, in a case where any one or two or more elements selected from the group consisting of Pd, Au, and Pt are contained as impurities, the atomic ratio (Pd + Au + Pt)/(Ge) may be less than 0.01.

Even in a case where In, Zn, and Sn are contained as impurities without being intentionally added, the atomic ratio (In + Zn + Sn + Pd + Au + Pt)/(Ge) may be set as described above.

(Film Thickness of Ag Alloy Film 11)

In the lamination film 10, it is possible to improve the transmittance by reducing the film thickness of the Ag alloy film 11.

Here, in a case where the film thickness of the Ag alloy film 11 is less than 3 nm, the Ag alloy film 11 is island-shaped and discontinuous, and the electrical resistance is significantly increased. In addition, since a uniform film is not formed, the transmittance is also significantly reduced. On the other hand, in a case where the film thickness of the Ag alloy film 11 exceeds 10 nm, the transmittance may be insufficient.

Therefore, in the embodiment, the film thickness of the Ag alloy film 11 is set in a range of 3 nm to10 nm.

The thickness of the Ag alloy film 11 is preferably 4 nm or more and more preferably 5 nm or more. On the other hand, the thickness of the Ag alloy film 11 is preferably 8 nm or less and more preferably 7 nm or less.

(Sheet Resistance)

In the embodiment, the sheet resistance of the lamination film 10 is set to 40Ω/□ or less. Accordingly, the lamination film 10 has excellent electrical characteristics and is particularly suitable as a transparent conductive wiring film and a transparent electrode.

In addition, a distribution DR = $(\sigma_R/\mu_R) \times 100$ of the sheet resistance defined by an average value $\mu_R$ and a standard deviation $\sigma_R$ of the sheet resistance measured at a plurality of in-plane points is 20% or less. In the embodiment, as shown in Fig. 3, in the plane of the lamination film 10, the sheet resistance was measured at five points of an intersection (1) at which diagonal lines intersect and corners (2), (3), (4), and (5) on each diagonal line, and the average value $\mu_R$, the standard deviation $\sigma_R$, and the distribution $D_R$ of the sheet resistance were calculated. Each of the corners (2), (3), (4), and (5) was within a range of 10% of a total length of the diagonal line from the corner towards the inside.

The distribution $D_R$ of the sheet resistance calculated by doing so is set to 20% or less. Accordingly, the Ag alloy film 11 does not become a discontinuous film and is formed to have a comparatively uniform film thickness.

The sheet resistance of the lamination film 10 is preferably 30Ω/□ or less and more preferably 25Ω/□ or less.

In addition, the distribution $D_R$ of the sheet resistance is preferably 18% or less and more preferably 15% or less.

(Average Transmittance)

In the embodiment, an average transmittance of the lamination film 10 at a wavelength of 380 nm to 780 nm is 85% or more. Accordingly, the lamination film 10 has excellent optical characteristics and is particularly suitable as a transparent conductive wiring film and a transparent electrode.

The average transmittance of the lamination film 10 at a wavelength range of 380 nm to 780 nm is preferably 88% or more and more preferably 90% or more.

(Refractive Index and Film Thickness of Transparent Conductive Oxide Film 12)

In the embodiment, in a case where the refractive index of the transparent conductive oxide film 12 at a wavelength of 550 nm is in a range of 1.9 to 2.4 and the film thickness of the transparent conductive oxide film 12 is in a range of 5 nm to 50 nm, it is possible to improve the visible light transmittance of the transparent conductive oxide film 12. Therefore, it is possible to improve the optical characteristics of the entire lamination film 10.

The refractive index of the transparent conductive oxide film 12 at a wavelength of 550 nm is preferably 2.0 or more and more preferably 2.2 or less. In addition, the film thickness of the transparent conductive oxide film 12 is preferably 10 nm or more and more preferably 40 nm or less.

<Ag Alloy Sputtering Target>

Next, the Ag alloy sputtering target 20 of the embodiment will be described. The Ag alloy sputtering target 20 is used for forming the Ag alloy film 11 forming the lamination film 10 according to the embodiment described above.
In addition, in the Ag alloy sputtering target 20 of the embodiment, in a case of forming a film on a comparatively large substrate 1, an area of the target surface (the sputtering target surface) is preferably 0.25 $m^2$ or more.
The Ag alloy sputtering target 20 of the embodiment contains Ge in a range of 5.0 atom% to 13.0 atom% and a balance of Ag and inevitable impurities.
The Ag alloy sputtering target 20 may further contain any one or two or more of elements selected from the group consisting of In, Zn, and Sn, and the atomic ratio (In + Zn + Sn)/(Ge) of the total amount (In + Zn + Sn) of any one or two or more selected from the group consisting of In, Zn, and Sn to the amount (Ge) of Ge may be in a range of 0.05 to 0.50.
In addition, the Ag alloy sputtering target 20 may further contain any one or two or more elements selected from the group consisting of Pd, Au, and Pt, the atomic ratio (Pd + Au + Pt)/(Ge) of the total amount (Pd + Au + Pt) of any one or two or more elements selected from the group consisting of Pd, Au, and Pt to the amount (Ge) of Ge may be 0.01 or more, and the atomic ratio (In + Zn + Sn + Pd + Au + Pt)/(Ge) of the total amount (In + Zn + Sn + Pd + Au + Pt) of any one or two or more elements selected from the group consisting of In, Zn, Sn, Pd, Au, and Pt to the amount (Ge) of Ge may be 0.50 or less.
In addition, regarding the Ag alloy sputtering target 20, the average value of the crystal grain sizes is 200 μm or less and the distribution $D_{GS} = (\sigma_{GS}/(\mu_{GS}) \times 100$ of crystal grain sizes defined by the average value $\mu_{GS}$ of the crystal grain sizes and the standard deviation $\sigma_{GS}$ of the crystal grain sizes measured at a plurality of points of a target surface is 25% or less.
Here, in the Ag alloy sputtering target 20 of the embodiment, the reasons for setting the component composition and the crystal grain size as described above will be described.

(Component Composition)

Since the Ag alloy sputtering target 20 of the embodiment forms the Ag alloy film 11 described above, the component composition thereof is set in accordance with the component composition of the Ag alloy film 11 of the embodiment described above.
Accordingly, the Ag alloy sputtering target 20 according to the embodiment has a amount of Ge in a range of 5.0 atom% to 13.0 atom%.
The amount of Ge in the Ag alloy sputtering target 20 is preferably 7.0 atom% or more and more preferably 9.0 atom% or more. On the other hand, the amount of Ge in the Ag alloy sputtering target 20 is preferably 12.0 atom% or less and more preferably 11.0 atom% or less.
In addition, in a case of including In, Zn, and Sn having an effect of suppressing the Ag diffusion, in the same manner as Ge, the atomic ratio (In + Zn + Sn)/(Ge) of the total amount (In + Zn + Sn) of any one or two or more selected from the group consisting of In, Zn, and Sn to the amount (Ge) of Ge is preferably in a range of 0.05 to 0.50.
The atomic ratio (In + Zn + Sn)/(Ge) is preferably 0.10 or more and more preferably 0.15 or more. On the other hand, the atomic ratio (In + Zn + Sn)/(Ge) is preferably 0.40 or less and more preferably 0.30 or less.
In addition, in order to improve the environment resistance of the formed Ag alloy film 11, in a case where Pd, Au, and Pt are contained, the atomic ratio (Pd + Au + Pt)/(Ge) of the total amount (Pd + Au + Pt) of any one or two or more selected from the group consisting of Pd, Au, and Pt to the amount (Ge) of Ge is preferably 0.01 or more, and the atomic ratio (In + Zn + Sn + Pd + Au + Pt)/(Ge) of the total amount (In + Zn + Sn + Pd + Au + Pt) of any one or two or more selected from the group consisting of In, Zn, Sn, Pd, Au, and Pt to the amount (Ge) of Ge is preferably 0.50 or less.
The atomic ratio (Pd + Au + Pt)/(Ge) is preferably 0.02 or more and more preferably 0.05 or more. On the other hand, the atomic ratio (In + Zn + Sn + Pd + Au + Pt)/(Ge) is preferably 0.40 or less and more preferably 0.30 or less.

(Crystal Grain Size)

In the Ag alloy sputtering target 20 of the embodiment, by setting the average value of the crystal grain sizes to 200 μm or less, it is possible to prevent an increase in surface roughness of the target surface, even in a case where the sputtering has proceeded. Accordingly, it is possible to suppress occurrence of abnormal discharge during sputtering and stably perform sputtering film formation.
In addition, by setting the distribution $D_{GS} = (\sigma_{GS}/(\mu_{GS}) \times 100$ of crystal grain sizes defined by the average value $\mu_{GS}$ of the crystal grain sizes and the standard deviation $\sigma_{GS}$ of the crystal grain sizes measured at a plurality of points of a target surface to 25% or less, a sputtering rate is comparatively constant over the entire target surface and it is possible to stably form the Ag alloy film 11 having a film thickness of 3 nm to 10 nm.

The average value of the crystal grain sizes of the Ag alloy sputtering target 20 is preferably 180 μm or less and more preferably 150 μm or less.

In addition, the distribution $D_{GS}$ of crystal grain sizes is preferably 20% or less, and more preferably 15% or less.

In the embodiment, as shown in Fig. 4, on the target surface of the Ag alloy sputtering target 20, crystal grain sizes were measured at five points of an intersection (1) at which diagonal lines intersect and corners (2), (3), (4), and (5) on each diagonal lines, and the average grain size $\mu_{GS}$, the standard deviation $\sigma_{GS}$ of the crystal grain sizes, and the distribution $D_{GS}$ were calculated. Each of the corners (2), (3), (4), and (5) was within a range of 10% of a total length of the diagonal line from the corner towards the inside.

As described above, the distribution $D_{GS}$ of the crystal grain size is suppressed to 25% or less on the target surface. Accordingly, it is possible to form the Ag alloy film 11 having a uniform film thickness.

<Method for Manufacturing Ag Alloy Sputtering Target>

Next, a method for manufacturing the Ag alloy sputtering target 20 according to the embodiment will be described.

First, an Ag raw material having a purity of 99.9 mass% or higher, a Ge raw material having a purity of 99.9 mass% or higher, and, as necessary, an In raw material, a Zn raw material, a Sn raw material, a Pd raw material, a Au raw material, or a Pt raw material having a purity of 99.9 mass% or higher are prepared.

Then, the Ag raw material is melted under high vacuum or in an inert gas atmosphere using a melting furnace, and a predetermined amount of the Ge raw material, and as necessary, the In raw material, the Zn raw material, the Sn raw material, the Pd raw material, the Au raw material, and the Pt raw material are added to the obtained Ag molten metal. After that, the mixture is melted under a high vacuum or in an inert gas atmosphere to produce an Ag alloy ingot having a predetermined composition.

Here, it is preferable that the Ag raw material is melted in an atmosphere of the melting furnace which is once evacuated to a high vacuum and then replaced with Ar, and the auxiliary raw materials are put in the Ar atmosphere, after melting.

A mother alloy containing Ge and (In, Zn, Sn, Pd, Au, Pt) may be used as the raw material.

Then, the obtained ingot is forged and rolled. The rolling is performed by hot rolling or cold rolling.

In a case of using the hot rolling, as a homogenizing heat treatment step before starting the rolling, it is preferable to perform heat treatment under the condition of holding at a temperature of 600°C to 700°C for 1 hour to 10 hours. In a case where the temperature is lower than 600°C, the homogenization may be insufficient, and in a case where the temperature exceeds 700°C, a liquid phase may appear in the ingot and the target may be softened or melted. In addition, in a case where the heat treatment time is shorter than 1 hour, the homogenization may be insufficient, and in a case where the heat treatment time exceeds 10 hours, the auxiliary raw materials in Ag may be internally oxidized.

Although the hot rolling is performed after the homogenizing heat treatment step, a temperature at the end of rolling is preferably 400°C to 700°C and intermediate annealing is preferably added depending on the case.

During the rolling, a total rolling reduction is preferably 70% or more and a rolling reduction of at least the final one pass of the rolling is preferably 20% or more. In a case where the rolling reduction is less than 20%, the crystal grain size is not sufficiently refined, and the internal crystal grain size is insufficiently uniform. From a viewpoint of capability of a rolling mill, the rolling reduction of 50% or more per pass is substantially not practical.

After the rolling, heat treatment is carried out for the homogenization of a crystal structure of a target material and a work hardening removal. The heat treatment is preferably performed under the condition of holding the heat treatment temperature in a range of 600°C to 700°C for 1 hour to 5 hours. In a case where the heat treatment temperature is lower than 600°C, the effect of the work hardening removal is not sufficient, and in a case where the heat treatment temperature exceeds 700°C, the crystal grains may become coarse or a liquid phase may appear to melt or soften the target. In addition, in a case where the heat treatment time is shorter than 1 hour, the homogenization becomes insufficient. After the heat treatment, the resultant material is rapidly cooled by air or water.

The Ag alloy sputtering target 20 according to the embodiment is manufactured through the steps described above.

<Method for Manufacturing Lamination Film>

Next, a method for manufacturing the lamination film 10 according to this embodiment will be described.

First, the transparent conductive oxide film 12 is formed on a surface of the substrate 1 formed of glass or the like. In the embodiment, a film is formed using a sputtering target formed of the transparent conductive oxide described above. In consideration of conductivity or the like of the sputtering target, it is preferable to appropriately select and use direct current (DC) sputtering, radio frequency (RF) sputtering, medium frequency (MF) sputtering, alternating current (AC) sputtering, and the like.

The Ag alloy film 11 is formed on the formed transparent conductive oxide film 12 by using the Ag alloy sputtering target 20 of the embodiment described above. At this time, the sputtering conditions are appropriately adjusted so that the film thickness of the Ag alloy film 11 is in a range of 3 nm to 10 nm.

At the time of sputtering, the sputtering rate is measured by measuring the film thickness after film formation for a certain period of time with a step gauge (DEKTAK-XT), and the film formation time is adjusted from that value to form a film with a target film thickness.

In addition, since the Ag alloy film 11 has a very thin film thickness of 10 nm or less, it is preferable to set the sputtering rate as slow as possible, from a viewpoint of film thickness control. Therefore, it is preferable to set the sputtering power as low as possible.

The transparent conductive oxide film 12 is formed on the Ag alloy film 11 formed as described above using the sputtering target formed of the transparent conductive oxide described above.

By doing so, the lamination film 10 of the embodiment is formed.

The lamination film 10 according to the embodiment configured as described above includes the Ag alloy film 11 containing Ge in a range of 5.0 atom% to 13.0 atom% and the film thickness of the Ag alloy film 11 is in a range of 3 nm to 10 nm. Accordingly, the diffusion of Ag is suppressed by Ge, and the Ag alloy film 11 does not have an island shape and has a comparatively uniform film thickness. In addition, even in a case where the film is formed in an atmosphere containing water vapor, it is possible to suppress the Ag aggregation, and even in the case of mass production, it is possible to prevent the Ag alloy film 11 from becoming a discontinuous film. Therefore, the sheet resistance and the transmittance are improved.

Specifically, the lamination film 10 has a sheet resistance of 40 Ω/□ or less and has an average transmittance of 85% or more at a wavelength range of 380 nm to 780 nm, thereby exhibiting excellent electrical characteristics and optical characteristics.

In addition, in the lamination film 10 of the embodiment, the distribution $D_R = (\sigma_R/\mu_R) \times 100$ of the sheet resistance defined by the average value $\mu_R$ and the standard deviation $\sigma_R$ of the sheet resistance measured at a plurality of in-plane points is 20% or less. Accordingly, the in-plane characteristics of the lamination film 10 are stable, and even in a case where the film thickness is 3 nm to 10 nm, the Ag alloy film 11 having a comparatively uniform film thickness is formed.

In addition, in the lamination film 10 of the embodiment, in a case where the Ag alloy film 11 further contains any one or two or more of elements selected from the group consisting of In, Zn, and Sn, and the atomic ratio (In + Zn + Sn)/(Ge) of the total amount (In + Zn + Sn) of any one or two or more selected from the group consisting of In, Zn, and Sn to the amount (Ge) of Ge is in a range of 0.05 to 0.50, it is possible to further suppress the Ag aggregation due to In, Zn, and Sn and prevent the Ag alloy film from becoming a discontinuous film. In addition, it is possible to prevent a deterioration in environment resistance and water vapor resistance due to In, Zn, and Sn.

Further, in the lamination film 10 of the embodiment, in a case where the Ag alloy film 11 further contains any one or two or more elements selected from the group consisting of Pd, Au, and Pt, the atomic ratio (Pd + Au + Pt)/(Ge) of the total amount (Pd + Au + Pt) of any one or two or more elements selected from the group consisting of Pd, Au, and Pt to the amount (Ge) of Ge is 0.01 or more, and the atomic ratio (In + Zn + Sn + Pd + Au + Pt)/(Ge) of the total amount (In + Zn + Sn + Pd + Au + Pt) of any one or two or more elements selected from the group consisting of In, Zn, Sn, Pd, Au, and Pt to the amount (Ge) of Ge is 0.50 or less, it is possible to further improve environment resistance of the lamination film 10 while ensuring electrical characteristics and optical characteristics of the lamination film 10.

In the lamination film 10 of the embodiment, the transparent conductive oxide film 12 is configured to contain any one or two or more selected from the group consisting of an In oxide, a Sn oxide, a Zn oxide, a Nb oxide, a Ti oxide, an Al oxide, and a Ga oxide. Accordingly, the electrical characteristics and optical characteristics of the transparent conductive oxide film 12 are excellent and it is possible to improve the optical characteristics and electrical characteristics of the entire lamination film 10.

The Ag alloy sputtering target 20 of the embodiment contains Ge in a range of 5.0 atom% to 13.0 atom% and the balance of Ag and inevitable impurities. Accordingly, the Ag diffusion is suppressed by these elements in a case of forming the Ag alloy film 11, and even in a case where the Ag alloy film 11 is formed thin to have a film thickness of 3 nm to 10 nm, it is possible to suppress the Ag aggregation and form the Ag alloy film 11 having a comparatively uniform film thickness.

In addition, in the Ag alloy sputtering target 20 of the embodiment, the average value of the crystal grain sizes is 200 μm or less and the distribution $D_{GS} =(\sigma_{GS}/(\mu_{GS}) \times 100$ of crystal grain sizes defined by the average value $\mu_{GS}$ of the crystal grain sizes and the standard deviation $\sigma_{GS}$ of the crystal grain sizes measured at a plurality of points of a target surface is 25% or less. Accordingly, a sputtering rate is comparatively constant over the entire target surface and it is possible to stably form the Ag alloy film 11 having a film thickness of 3 nm to 10 nm.

In addition, in a case where the Ag alloy sputtering target 20 of the embodiment further contains any one or two or more of elements selected from the group consisting of In, Zn, and Sn, and the atomic ratio (In + Zn + Sn)/(Ge) of the total amount (In + Zn + Sn) of any one or two or more selected from the group consisting of In, Zn, and Sn to the amount (Ge) of Ge is in a range of 0.05 to 0.50, it is possible to suppress the Ag aggregation even in the thin Ag alloy film 11 having a film thickness of 3 nm to 10 nm and stably form the Ag alloy film 11. In addition, it is possible to prevent a deterioration in environment resistance and water vapor resistance due to In, Zn, and Sn and prevent the Ag aggregation, even in a case where the film is formed in an atmosphere containing water vapor.

Further, in a case where the Ag alloy sputtering target 20 further contains any one or two or more elements selected from the group consisting of Pd, Au, and Pt, the atomic ratio (Pd + Au + Pt)/(Ge) of the total amount (Pd + Au + Pt) of any one or two or more elements selected from the group consisting of Pd, Au, and Pt to the amount (Ge) of Ge is 0.01 or more, and the atomic ratio (In + Zn + Sn + Pd + Au + Pt)/(Ge) of the total amount (In + Zn + Sn + Pd + Au + Pt) of any one or two or more elements selected from the group consisting of In, Zn, Sn, Pd, Au, and Pt to the amount (Ge) of Ge is 0.50 or less, it is possible to further improve environment resistance of the Ag alloy film 11 while ensuring electrical characteristics and optical characteristics of the Ag alloy film 11.

Although the embodiment of the present invention has been described above, the present invention is not limited thereto and can be appropriately modified within a range not departing from the technical idea of the invention.

For example, although the lamination film is formed on the glass substrate in the embodiment, but the present invention is not limited thereto, and the lamination film according to the embodiment may be formed on a resin substrate, a resin film, or the like.

In addition, in the embodiment, as shown in Fig. 1, the lamination film having a three-layer structure in which one layer of the Ag alloy film 11 is formed and the transparent conductive oxide films 12 are formed on both surfaces of the Ag alloy film 11 is formed. However, there is no limitation thereto, and for example, as shown in Fig. 5, a lamination film 110 having a five-layer structure in which two layers of the Ag alloy film 11 are formed and the transparent conductive oxide films 12 are laminated on both surfaces of each Ag alloy film 11 may be formed, or a lamination film in which three or more layers of the Ag alloy film are formed and the transparent conductive films are formed on both surfaces of each Ag alloy film may be formed.

In addition, as shown in Fig. 6, a lamination film 210 in which the Ag alloy film 11 is formed on the substrate 1 and the transparent conductive oxide film 12 is formed on the Ag alloy film 11 may be used.

In addition, as shown in Fig. 7, a lamination film 310 in which the transparent conductive oxide film 12 is formed on the substrate 1 and the Ag alloy film 11 is formed on the transparent conductive oxide film 12 may be used.

In other words, a lamination film in which the transparent conductive oxide film 12 is formed only on one surface side of the Ag alloy film 11 may be used.

In addition, in the embodiment, the transparent conductive oxide film 12 is formed by using a sputtering target formed of an oxide, but there is no limitation thereto, and the film may be formed by performing reactive sputtering in an oxygen atmosphere using the sputtering target formed of the metal described above (In, Sn, Zn, Nb, Ti, Al, and Ga).

In addition, in the embodiment, the target surface has a rectangular shape, but there is no limitation thereto, and the target surface may have a circular shape, or may have a cylindrical sputtering target having a cylindrical surface.

In addition, in a sputtering target having a circular target surface, as shown in Fig. 8, the crystal grain sizes are preferably measured at five points of a center (1) of the circle and outer peripheral portions (2), (3), (4), and (5) passing through the center of the circle and two straight lines orthogonal to each other. Each of the outer peripheral portions (2), (3), (4), and (5) was within a range of 10% of a diameter from the outer peripheral line towards the inside.

In addition, in a cylindrical sputtering target having a cylindrical target surface, as shown in Figs. 9A and 9B, the crystal grain sizes are preferably measured at four points of (1), (2), (3), and (4) at intervals of 90° in an outer peripheral direction from the half point in an axis O direction.

## EXAMPLES

The results of confirmation experiments performed to confirm the effectiveness of the present invention will be described below.

An Ag raw material having a purity of 99.9 mass% or more was prepared, the Ag raw material was melted in a vacuum atmosphere, the atmosphere was replaced with Ar gas, Ge having a purity of 99.9 mass% or more and an auxiliary raw material including In, Zn, Sn, Pd, An, and Pt was added, and an Ag alloy molten metal having a predetermined composition was prepared. Then, the molten Ag alloy was cast to produce an Ag alloy ingot.

(Component Composition)

A sample for analysis was collected from the obtained Ag alloy ingot, and the component composition was measured by ICP emission spectroscopy. The measurement results are shown in Table 1 as the component composition of the Ag alloy sputtering target.

The obtained Ag alloy ingot was homogenized at 650°C for 2 hours. After performing the homogenization treatment, hot rolling was performed. The rolling end temperature was set to 500°C and the total rolling reduction was 80%. In addition, the rolling reduction of the final pass of rolling was set to 20%.

After the hot rolling, heat treatment was performed under the condition of 650°C for 1 hour. After the heat treatment, the resultant material was rapidly cooled with water.

In Comparative Example 6, the total rolling reduction was set to 80% and the heat treatment conditions after the rolling were 800°C for 1 hour.

In Comparative Example 7, the total rolling reduction was set to 40% and the heat treatment conditions after the rolling were 650°C for 1 hour.

By doing so, a plate material having a length of 2,000 mm, a width of 200 mm, and a thickness of 8 mm was obtained.

(Crystal Grain Size)

In the obtained plate material, an average value and a distribution of crystal grain sizes on the target surface were measured as follows.

A measurement sample was collected from the positions shown in Fig. 4, the target surface of each measurement sample was polished as an observation surface, and then, an etching treatment was performed.

Then, a mixed solution of a hydrogen peroxide solution and ammonia water was used as an etching solution, and the observation surface was etched by immersing the measurement sample in the etching solution at room temperature for 1 to 2 seconds.

The etched observation surface was observed with an optical microscope to obtain a structure photograph. Using this structure photograph, the particle size was measured by a cutting method based on the international standard ASTM E-112, ASTM particle size number G was calculated, and an average particle size corresponding to the ASTM particle size number G was obtained. At this time, twin crystals were excluded from the measurement. One measurement sample was measured in 3 fields of view, and an average value thereof was used as the crystal grain size of the measurement sample. The observation was performed by appropriately selecting an observation magnification in accordance with the crystal grain size.

The average value $\mu_{GS}$ and the standard deviation $\sigma_{GS}$ of the crystal grain sizes of the entire plate material were calculated from the five-point average of the crystal grain sizes obtained from the measurement samples at each of five points. Then, the distribution $D_{GS} = (\sigma_{GS}/\mu_{GS}) \times 100$ (%) was calculated using the average value $\mu_{GS}$ and the standard deviation $\sigma_{GS}$ of these crystal grain sizes. The measurement results are shown in Table 1 as the crystal grain size of the Ag alloy sputtering target.

Next, the plate material described above was cut and machined to manufacture an Ag alloy sputtering target having a predetermined dimension (126 mm $\times$ 178 mm $\times$ thickness of 6 mm).

A lamination film was formed as follows using the Ag alloy sputtering target described above.

First, as a substrate, a glass substrate having a size of 10 cm $\times$ 30 cm (EAGLEXG manufactured by Corning) was prepared.

In addition, a sputtering target having the following composition was prepared as the sputtering target for forming the transparent conductive oxide film.

ITO: $In_2O_3$-10 mass% $SnO_2$
IZO: $In_2O_3$-10 mass% ZnO
$TiO_x$: $TiO_2$
$NbO_x$: $Nb_2O_5$

Here, the refractive index at a wavelength of 550 nm of the transparent conductive oxide film formed by the sputtering target described above is as follows.

ITO film: 2.1
IZO film: 2.0
$TiO_x$ film: 2.4
NbOx film: 2.4

The sputtering target and Ag alloy sputtering target described above were soldered to a backing plate formed of oxygen-free copper, and this was mounted on a sputtering device. In the embodiment, a magnetron DC sputtering device was used. In addition, in the embodiment, a substrate transfer type sputtering device was used.

Then, the sputtering was performed under the following conditions to form the transparent conductive oxide film and the Ag alloy film on the substrate to obtain a lamination film having a layer structure shown in Table 2. After the film formation, the heat treatment was performed in the atmosphere at 230°C for 15 minutes using an infrared image furnace.

Film formation start vacuum degree: $1.0 \times 10^{-4}$ Pa or less
Sputtering gas: High-purity argon

Sputtering gas pressure in chamber: 0.4 Pa
DC power: 100 W

(Composition of Ag Alloy Film)

Separately from the lamination film, an Ag alloy film was formed on a substrate to have a thickness of 1,000 nm and the component composition thereof was measured by ICP emission spectroscopy. Accordingly, it is confirmed that the component composition of the Ag alloy film was the same as the component composition of the Ag alloy sputtering target.

(Film Thickness Measurement)

In a case of forming a film by sputtering, the sputtering rate is measured by measuring the film thickness after film formation for a certain period of time with a step gauge (DEKTAK-XT), and the film formation time is adjusted based on the value thereof to form a film with a target thickness. Since the film thickness of the Ag alloy film is extremely thin as 10 nm or less, it is preferable to decrease the sputtering rate as slow as possible for controlling the film thickness.
The actual lamination film was confirmed by observing the cross section of the lamination film with a transmission electron microscope (TEM), and it was confirmed that the film thickness was formed as intended. For sample preparation for the TEM observation, for example, a cross section polisher (CP) or a focused ion beam (FIB) can be used.
Then, the lamination film obtained as described above was evaluated for sheet resistance, transmittance, environment resistance, and water vapor resistance as follows. The evaluation results are shown in Table 3.

(Sheet Resistance)

The sheet resistance of the lamination film was measured by a four-point probe method using a resistance meter Loresta GP manufactured by Mitsubishi Chemical Corporation.
In addition, a substrate piece was collected from each point of a glass substrate having a size of 10 cm × 30 cm shown in Fig. 3, the sheet resistance was evaluated, the average value $\mu_R$ in the 5-point measurement of the sheet resistance and the standard deviation $\sigma_R$ in the 5-point measurement of the sheet resistance were measured, and the distribution $D_R = (\sigma_R/\mu_R) \times 100$ (%) of sheet resistance was calculated. The evaluation results are shown in Table 3.

(Transmittance)

The transmittance of the lamination film was measured using a spectrophotometer (U-4100 manufactured by Hitachi High-Technologies Corporation). Table 3 shows average values of the transmittance at a wavelength of 380 nm to 780 nm.
Since a measurement baseline was measured on a glass substrate during the measurement, the value shown in the table was a relative transmittance in a case where the transmittance of the substrate was set to 100.

(Environment Resistance)

As a constant temperature and constant humidity test, the lamination film was held in an environment of temperature 85°C and humidity 85% for 250 hours, the sheet resistance of the film after the test was measured, and a change rate before and after the test was evaluated.

$$\text{(Change rate)} = \text{(sheet resistance after test} - \text{sheet resistance before test)/(sheet resistance before test)} \times 100\ (\%)$$

(Water Vapor Resistance)

In a case of forming the lamination film, water vapor ($H_2O$) was introduced into Ar gas so that a partial pressure ratio was 4%. Then, the sheet resistance and the transmittance of the formed lamination film were measured as described above. The measurement results are shown in Table 3.

[Table 1]

| | | Composition of target (atom%) | | | | | | | | (In + Zn + Sn) / (Ge) | (Pd + Au + Pt) / (Ge) | (In + Zn + Sn + Pd + Au + Pt)/ (Ge) | Crystal grain size | |
|---|---|---|---|---|---|---|---|---|---|---|---|---|---|---|
| | | Ge | In | Zn | Sn | Pd | Au | Pt | Ag | | | | Average $\mu_{GS}$ ($\mu$m) | Distribution $D_{GS}$ (%) |
| Invention Example | 1 | 5.0 | - | - | - | - | - | - | Balance | - | - | - | 98 | 13 |
| | 2 | 10.0 | - | - | - | - | - | - | Balance | - | - | - | 112 | 14 |
| | 3 | 13.0 | - | - | - | - | - | - | Balance | - | - | - | 120 | 12 |
| | 4 | 10.0 | 0.5 | - | - | - | - | - | Balance | 0.05 | - | - | 102 | 14 |
| | 5 | 10.0 | 5.0 | - | - | - | - | - | Balance | 0.50 | - | - | 120 | 11 |
| | 6 | 10.0 | - | 0.5 | - | - | - | - | Balance | 0.05 | - | - | 100 | 13 |
| | 7 | 10.0 | - | 5.0 | - | - | - | - | Balance | 0.50 | - | - | 121 | 12 |
| | 8 | 9.9 | - | - | 0.5 | - | - | - | Balance | 0.05 | - | - | 98 | 9 |
| | 9 | 10.0 | - | - | 5.0 | - | - | - | Balance | 0.50 | - | - | 102 | 10 |
| | 10 | 10.0 | - | - | - | 0.05 | - | - | Balance | - | 0.01 | 0.01 | 87 | 9 |
| | 11 | 10.0 | - | - | - | 4.98 | - | - | Balance | - | 0.50 | 0.50 | 114 | 10 |
| | 12 | 10.0 | - | - | - | - | 0.07 | - | Balance | - | 0.01 | 0.01 | 98 | 11 |
| | 13 | 10.0 | - | - | - | - | 4.99 | - | Balance | - | 0.50 | 0.50 | 112 | 13 |
| | 14 | 10.0 | - | - | - | - | - | 0.05 | Balance | - | 0.01 | 0.01 | 92 | 14 |
| | 15 | 10.0 | - | - | - | - | - | 5.00 | Balance | - | 0.50 | 0.50 | 120 | 13 |
| | 16 | 7.0 | - | - | 2.0 | 1.00 | - | - | Balance | 0.29 | 0.14 | 0.43 | 87 | 14 |
| | 17 | 7.0 | - | - | 2.0 | - | 1.00 | - | Balance | 0.29 | 0.14 | 0.43 | 75 | 15 |
| | 18 | 7.0 | - | - | 2.0 | - | - | 1.00 | Balance | 0.29 | 0.14 | 0.43 | 98 | 16 |

(continued)

| | | Composition of target (atom%) | | | | | | | | (In + Zn + Sn) / (Ge) | (Pd + Au + Pt) / (Ge) | (In + Zn + Sn + Pd + Au + Pt)/ (Ge) | Crystal grain size | |
|---|---|---|---|---|---|---|---|---|---|---|---|---|---|---|
| | | Ge | In | Zn | Sn | Pd | Au | Pt | Ag | | | | Average $\mu_{GS}$ ($\mu$m) | Distribution $D_{GS}$ (%) |
| Comparative Example | 1 | 3.0 | - | - | - | - | - | - | Balance | - | - | - | 89 | 10 |
| | 2 | 15.0 | - | - | - | - | - | - | Balance | - | - | - | Crack occurred during rolling | |
| | 3 | 7.0 | 8.0 | - | - | - | - | - | Balance | 1.14 | - | - | 108 | 19 |
| | 4 | 7.0 | - | - | - | - | 8.00 | - | Balance | - | 1.14 | 1.14 | 99 | 18 |
| | 5 | 7.0 | - | - | 3.0 | - | 2.00 | - | Balance | 0.43 | 0.29 | 0.71 | 87 | 14 |
| | 6 | 10.0 | - | - | - | - | - | - | Balance | - | - | - | 289 | 11 |
| | 7 | 10.0 | - | - | - | - | - | - | Balance | - | - | - | 241 | 40 |

[Table 2]

| | | Lamination film | | | | | |
|---|---|---|---|---|---|---|---|
| | | First layer | | Second layer | | Third layer | |
| | | Material | Thickness | Material | Thickness | Material | Thickness |
| Invention Example | 101 | ITO | 10 nm | Invention Example 1 | 5 nm | ITO | 10 nm |
| | 102 | ITO | 10 nm | Invention Example 2 | 5 nm | ITO | 10 nm |
| | 103 | ITO | 10 nm | Invention Example 3 | 5 nm | ITO | 10 nm |
| | 104 | ITO | 10 nm | Invention Example 4 | 5 nm | ITO | 10 nm |
| | 105 | ITO | 10 nm | Invention Example 5 | 5 nm | ITO | 10 nm |
| | 106 | ITO | 10 nm | Invention Example 6 | 5 nm | ITO | 10 nm |
| | 107 | ITO | 10 nm | Invention Example 7 | 5 nm | ITO | 10 nm |
| | 108 | ITO | 10 nm | Invention Example 8 | 5 nm | ITO | 10 nm |
| | 109 | ITO | 10 nm | Invention Example 9 | 5 nm | ITO | 10 nm |
| | 110 | ITO | 10 nm | Invention Example 10 | 5 nm | ITO | 10 nm |
| | 111 | ITO | 10 nm | Invention Example 11 | 5 nm | ITO | 10 nm |
| | 112 | ITO | 10 nm | Invention Example 12 | 5 nm | ITO | 10 nm |
| | 113 | ITO | 10 nm | Invention Example 13 | 5 nm | ITO | 10 nm |
| | 114 | ITO | 10 nm | Invention Example 14 | 5 nm | ITO | 10 nm |
| | 115 | ITO | 10 nm | Invention Example 15 | 5 nm | ITO | 10 nm |
| | 116 | ITO | 10 nm | Invention Example 16 | 5 nm | ITO | 10 nm |
| | 117 | ITO | 10 nm | Invention Example 17 | 5 nm | ITO | 10 nm |
| | 118 | ITO | 10 nm | Invention Example 18 | 5 nm | ITO | 10 nm |
| | 119 | ITO | 10 nm | Invention Example 2 | 3 nm | ITO | 10 nm |
| | 120 | ITO | 10 nm | Invention Example 2 | 8 nm | ITO | 10 nm |
| | 121 | ITO | 10 nm | Invention Example 2 | 3 nm | - | - |

(continued)

| | | Lamination film | | | | | |
|---|---|---|---|---|---|---|---|
| | | First layer | | Second layer | | Third layer | |
| | | Material | Thickness | Material | Thickness | Material | Thickness |
| | 122 | Invention Example 2 | 3 nm | ITO | 10 nm | - | - |
| | 123 | IZO | 10 nm | Invention Example 2 | 5 nm | IZO | 10 nm |
| | 124 | NbOx | 10 nm | Invention Example 2 | 5 nm | NbOx | 10 nm |
| | 125 | TiOx | 10 nm | Invention Example 2 | 5 nm | TiOx | 10 nm |
| | 126 | ITO | 30 nm | Invention Example 2 | 5 nm | ITO | 30 nm |
| | 127 | ITO | 5 nm | Invention Example 2 | 5 nm | ITO | 50 nm |
| Comparative Example | 101 | ITO | 10 nm | Comparative Example 1 | 5 nm | ITO | 10 nm |
| | 102 | ITO | 10 nm | Comparative Example 3 | 5 nm | ITO | 10 nm |
| | 103 | ITO | 10 nm | Comparative Example 4 | 5 nm | ITO | 10 nm |
| | 104 | ITO | 10 nm | Comparative Example 5 | 5 nm | ITO | 10 nm |
| | 105 | ITO | 10 nm | Comparative Example 6 | 5 nm | ITO | 10 nm |
| | 106 | ITO | 10 nm | Comparative Example 7 | 5 nm | ITO | 10 nm |
| | 107 | ITO | 10 nm | Comparative Example 2 | 2 nm | ITO | 10 nm |
| | 108 | ITO | 10 nm | Comparative Example 2 | 10 nm | ITO | 10 nm |

[Table 3]

| | | Sheet resistance | | Transmittance (%) | Change rate of sheet resistance after constant temperature and constant humidity test (%) | During water vapor introduction | |
|---|---|---|---|---|---|---|---|
| | | Average $\mu_R$ (Ω/□) | Distribution $D_R$ (%) | | | Sheet resistance (Ω/□) | Transmittance (%) |
| | 101 | 15 | 7 | 91.3 | 12 | 19 | 91.1 |
| | 102 | 17 | 8 | 91.4 | 6 | 18 | 91.4 |
| | 103 | 18 | 7 | 91.4 | 6 | 19 | 91.4 |

(continued)

| | | Sheet resistance | | Transmittance (%) | Change rate of sheet resistance after constant temperature and constant humidity test (%) | During water vapor introduction | |
|---|---|---|---|---|---|---|---|
| | | Average $\mu_R$ (Ω/□) | Distribution $D_R$ (%) | | | Sheet resistance (Ω/□) | Transmittance (%) |
| Invention Example | 104 | 14 | 10 | 91.8 | 8 | 15 | 91.6 |
| | 105 | 15 | 9 | 91.7 | 9 | 23 | 91.3 |
| | 106 | 15 | 10 | 92.0 | 7 | 16 | 91.7 |
| | 107 | 16 | 8 | 91.6 | 9 | 22 | 91.1 |
| | 108 | 14 | 8 | 91.4 | 10 | 19 | 91.3 |
| | 109 | 15 | 7 | 91.7 | 11 | 23 | 91.2 |
| | 110 | 17 | 6 | 91.4 | 4 | 20 | 91.3 |
| | 111 | 19 | 10 | 91.0 | 2 | 23 | 90.6 |
| | 112 | 17 | 11 | 91.4 | 3 | 20 | 91.2 |
| | 113 | 19 | 9 | 91.1 | 1 | 24 | 90.5 |
| | 114 | 17 | 10 | 91.4 | 4 | 20 | 91.1 |
| | 115 | 19 | 11 | 90.9 | 1 | 25 | 90.2 |
| | 116 | 16 | 11 | 91.2 | 1 | 25 | 90.8 |
| | 117 | 16 | 10 | 91.5 | 1 | 25 | 90.9 |
| | 118 | 15 | 11 | 91.1 | 1 | 25 | 90.6 |
| | 119 | 31 | 14 | 94.0 | 12 | 38 | 93.4 |
| | 120 | 8 | 6 | 86.5 | 5 | 9 | 88.1 |
| | 121 | 31 | 13 | 90.7 | 14 | 38 | 90.2 |
| | 122 | 32 | 14 | 93.1 | 12 | 39 | 92.7 |
| | 123 | 16 | 11 | 91.5 | 6 | 20 | 91.2 |
| | 124 | 20 | 11 | 92.0 | 5 | 21 | 91.7 |
| | 125 | 21 | 12 | 92.2 | 6 | 22 | 91.5 |
| | 126 | 17 | 7 | 92.0 | 5 | 18 | 92.0 |
| | 127 | 17 | 7 | 88.0 | 4 | 18 | 88.2 |
| Comparative Example | 101 | 16 | 7 | 91.1 | >100 | 58 | 84.8 |
| | 102 | 18 | 7 | 91.1 | 60 | 60 | 84.1 |
| | 103 | 21 | 9 | 91.0 | 1 | 71 | 84.5 |
| | 104 | 20 | 8 | 90.9 | 1 | 88 | 84.0 |
| | 105 | 17 | 40 | 91.2 | 6 | 20 | 91.1 |
| | 106 | 17 | 37 | 91.4 | 5 | 21 | 91.2 |
| | 107 | 56 | 17 | 95.0 | 20 | 66 | 93.0 |
| | 108 | 5 | 4 | 78.0 | 5 | 5 | 79.1 |

In Comparative Example 101, the Ag alloy film was formed using the Ag alloy sputtering target of Comparative Example 1 having the amount of Ge of 3.0 atom% which is lower than the range of the present invention. The environment resistance was not sufficient and the water vapor resistance was not sufficient, either.

In Comparative Example 102, the Ag alloy film was formed using the Ag alloy sputtering target of Comparative Example 3 having the atomic ratio (In + Zn + Sn)/(Ge) of 1.14 which is greater than the range of the present invention. The environment resistance was not sufficient and the water vapor resistance was not sufficient, either.

In Comparative Examples 103 and 104, the Ag alloy film was formed using the Ag alloy sputtering target of Comparative Examples 4 and 5 having the atomic ratios (In + Zn + Sn + Pd + Au + Pt)/(Ge) of 1.14 and 0.71, respectively, which are greater than the range of the present invention. The water vapor resistance was not sufficient.

In Comparative Example 105, the Ag alloy film was formed using the Ag alloy sputtering target of Comparative Example 6 having the average crystal grain size $\mu_{GS}$ of 289 $\mu$m which is greater than the range of the present invention. The distribution $D_R$ of the sheet resistance was great. Accordingly, the Ag alloy film having uniform properties in the plane was hardly formed.

In Comparative Example 106, the Ag alloy film was formed using the Ag alloy sputtering target of Comparative Example 7 having an average crystal grain size $\mu_{GS}$ of 241 $\mu$m and a distribution $D_{GS}$ of 40%, which are greater than the range of the present invention. The distribution $D_R$ of the sheet resistance was great. Accordingly, the Ag alloy film having uniform properties in the plane was hardly formed.

In Comparative Example 107, the Ag alloy film having a film thickness of 2 nm was formed using the Ag alloy sputtering target of Comparative Example 2 having the amount of Ge of 15.0 atom% which is greater than the range of the present invention. The sheet resistance was high and the electrical characteristics were not sufficient.

In Comparative Example 108, the Ag alloy film having a film thickness of 10 nm was formed using the Ag alloy sputtering target of Comparative Example 2 having the amount of Ge of 15.0 atom% which is greater than the range of the present invention. The transmittance was low and the optical characteristics were not sufficient.

On the other hand, in the lamination films of Inventive Examples 101 to 127 in which the Ag alloy film having a film thickness of 3 nm to 10 nm was formed using the Ag alloy sputtering target of Inventive Examples 1 to 18, it was confirmed that the sheet resistance of the lamination film was 32 Ω/□ or less, the transmittance of the lamination film was 86.5% or more, and the electrical characteristics and the optical characteristics were excellent. In addition, it was also confirmed that the change rate in sheet resistance after the constant temperature and constant humidity test was comparatively small, and the environment resistance was also excellent.

Further, it was confirmed that, even in a case where water vapor was introduced at the time of film formation, the sheet resistance and the transmittance were excellent, and the water vapor resistance was excellent.

In addition, the distribution of the sheet resistance measured at a plurality of in-plane points was 20% or less, and it was confirmed that the Ag alloy film having a uniform film thickness was formed.

In addition, in Invention Example 121, the lamination film having a two-layer structure in which the transparent conductive oxide film was formed on the substrate and the Ag alloy film was formed on one surface of the transparent conductive oxide film, and in Invention Example 122, the transparent conductive oxide film was formed on one surface of the Ag alloy film, but the same effects were confirmed in both examples.

From the above, according to Invention Examples, for example, by setting the film thickness of the Ag alloy film to 10 nm or less, it is possible to provide the lamination film having excellent electrical characteristics and optical characteristics and particularly suitable for the transparent conductive wiring film or the transparent electrode, and the Ag alloy sputtering target used in a case of forming the Ag alloy film forming the lamination film.

[Reference Signs List]

10,110,210,310 lamination film
11 Ag alloy film
11AG Distribution of Ag
11Ge Distribution of Ge
12 Transparent conductive oxide film
20 Ag alloy sputtering target

## Claims

**1.** A lamination film comprising:

an Ag alloy film; and
a transparent conductive oxide film laminated on one or both surfaces of the Ag alloy film,
wherein the Ag alloy film contains Ge in a range of 5.0 atom% to 13.0 atom%, and a balance of Ag and inevitable impurities, and
the Ag alloy film has a film thickness in a range of 3 nm to 10 nm.

**2.** The lamination film according to claim 1,
wherein the Ag alloy film further contains any one or two or more of elements selected from the group consisting of In, Zn, and Sn, and
an atomic ratio (In + Zn + Sn)/(Ge) of a total amount (In + Zn + Sn) of any one or two or more selected from the group consisting of In, Zn, and Sn to an amount (Ge) of Ge is in a range of 0.05 to 0.50.

**3.** The lamination film according to claim 1 or 2,
wherein the Ag alloy film further contains any one or two or more elements selected from the group consisting of Pd, Au, and Pt,
an atomic ratio (Pd + Au + Pt)/(Ge) of a total amount (Pd + Au + Pt) of any one or two or more elements selected from the group consisting of Pd, Au, and Pt to an amount (Ge) of Ge is 0.01 or more, and
an atomic ratio (In + Zn + Sn + Pd + Au + Pt)/(Ge) of a total amount (In + Zn + Sn + Pd + Au + Pt) of any one or two or more elements selected from the group consisting of In, Zn, Sn, Pd, Au, and Pt to the amount (Ge) of Ge is 0.50 or less.

**4.** The lamination film according to any one of claims 1 to 3,
wherein a sheet resistance of the lamination film is set to 40 Ω/□ or less, and
a distribution $D_R = (\sigma_R/\mu_R) \times 100$ of the sheet resistance defined by an average value $\mu_R$ and a standard deviation $\sigma_R$ of the sheet resistance measured at a plurality of in-plane points is 20% or less.

**5.** The lamination film according to any one of claims 1 to 4,
wherein the transparent conductive oxide film includes any one or two or more selected from the group consisting of an In oxide, a Sn oxide, a Zn oxide, a Nb oxide, a Ti oxide, an Al oxide, and a Ga oxide.

**6.** The lamination film according to any one of claims 1 to 5,
wherein the transparent conductive oxide film has a refractive index in a range of 1.9 to 2.4 at a wavelength of 550 nm and has a film thickness in a range of 5 nm to 50 nm.

**7.** An Ag alloy sputtering target comprising:

Ge in a range of 5.0 atom% to 13.0 atom%; and
a balance of Ag and inevitable impurities,
wherein an average value of crystal grain sizes is 200 μm or less, and
a distribution, $D_{GS} = (\sigma_{GS}/\mu_{GS}) \times 100$, of the crystal grain sizes defined by an average value $\mu_{GS}$ of the crystal grain sizes and a standard deviation $\sigma_{GS}$ of the crystal grain sizes measured at a plurality of points of a target surface is 25% or less.

**8.** The Ag alloy sputtering target according to claim 7, further comprising:

any one or two or more of elements selected from the group consisting of In, Zn, and Sn,
wherein an atomic ratio (In + Zn + Sn)/(Ge) of a total amount (In + Zn + Sn) of any one or two or more selected from the group consisting of In, Zn, and Sn to an amount (Ge) of Ge is in a range of 0.05 to 0.50.

**9.** The Ag alloy sputtering target according to claim 7 or 8, further comprising:

any one or two or more elements selected from the group consisting of Pd, Au, and Pt,
wherein an atomic ratio (Pd + Au + Pt)/(Ge) of a total amount (Pd + Au + Pt) of any one or two or more elements selected from the group consisting of Pd, Au, and Pt to an amount (Ge) of Ge is 0.01 or more, and
an atomic ratio (In + Zn + Sn + Pd + Au + Pt)/(Ge) of a total amount (In + Zn + Sn + Pd + Au + Pt) of any one or two or more elements selected from the group consisting of In, Zn, Sn, Pd, Au, and Pt to the amount (Ge) of Ge is 0.50 or less.

FIG. 1

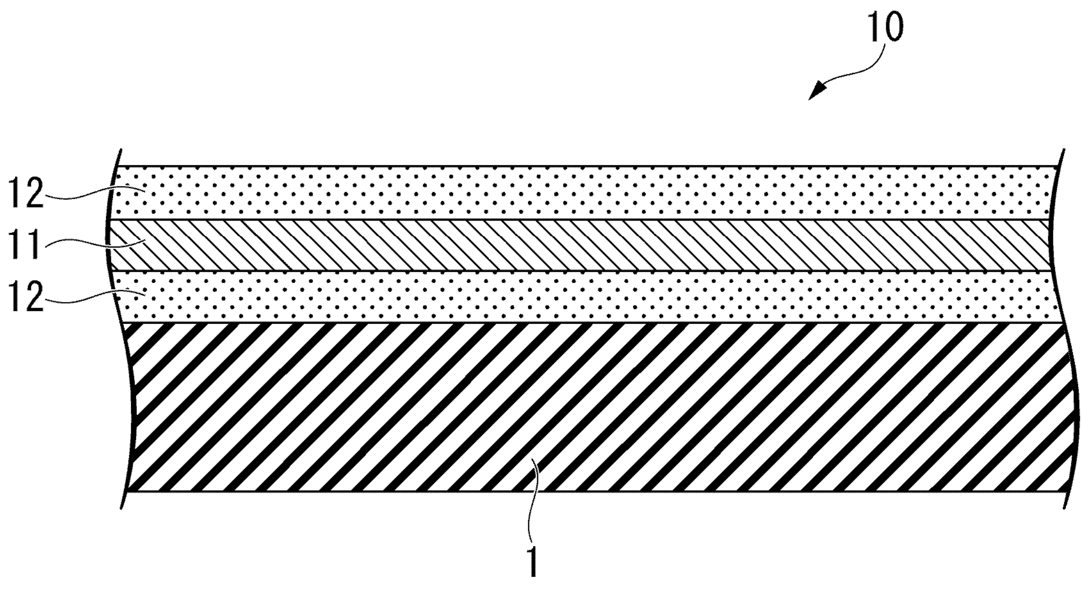

FIG. 2A

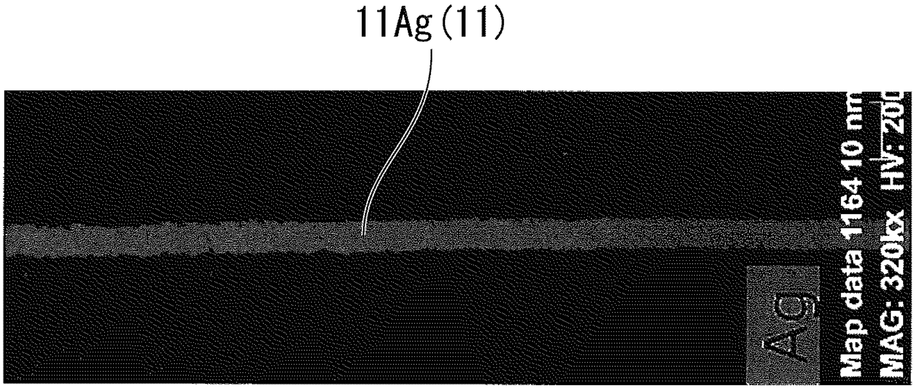
11Ag (11)
Ag
Map data 1164 10 nm
MAG: 320kx HV: 200

FIG. 2B

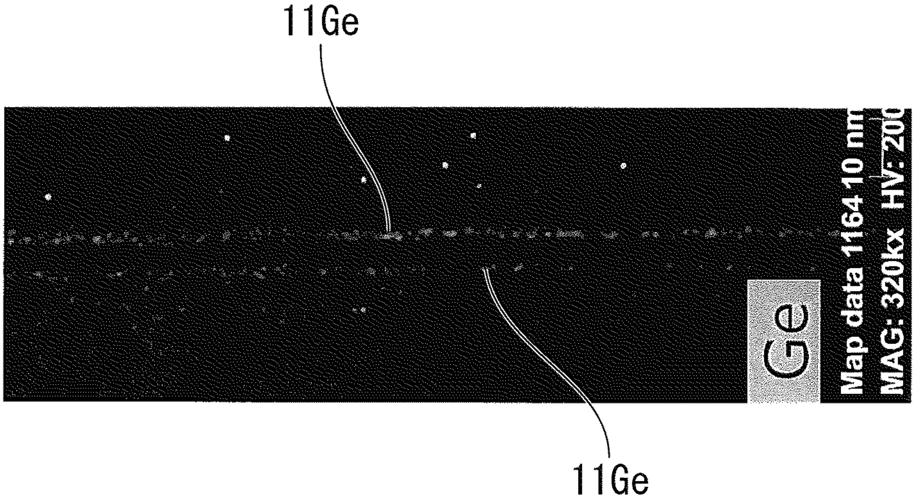
11Ge
Ge
Map data 1164 10 nm
MAG: 320kx HV: 200
11Ge

FIG. 3

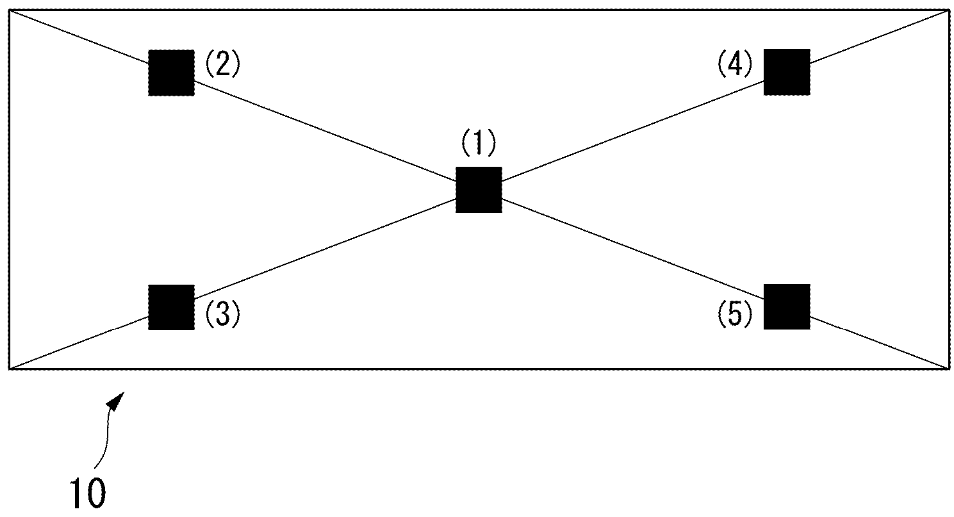

FIG. 4

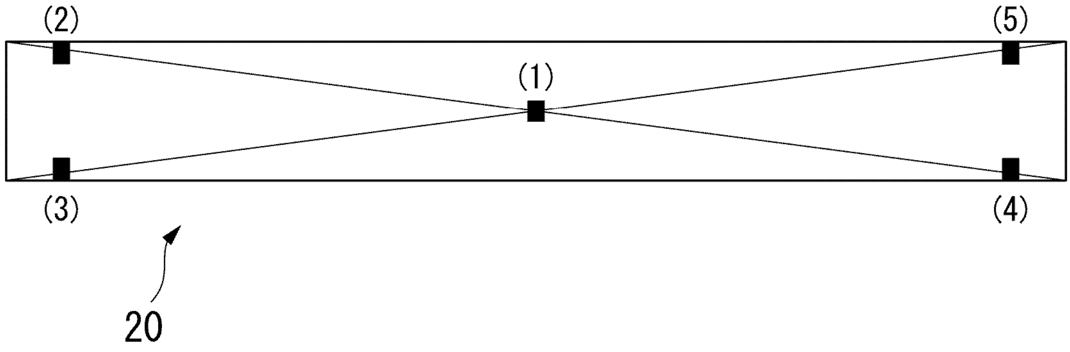


FIG. 5

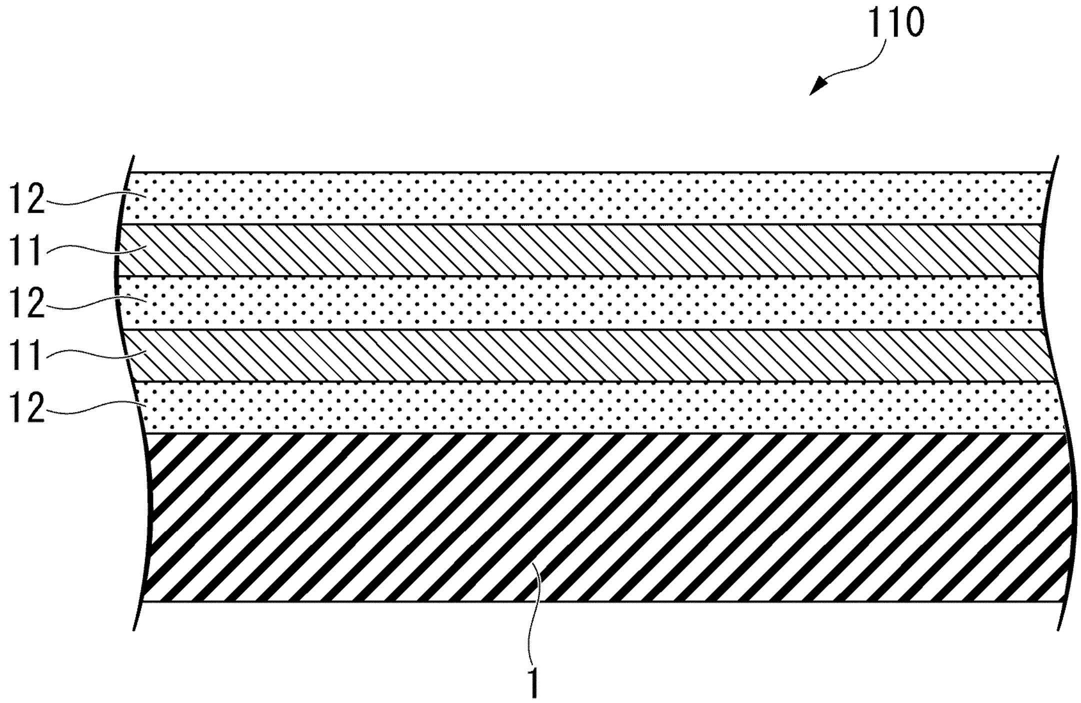

FIG. 6

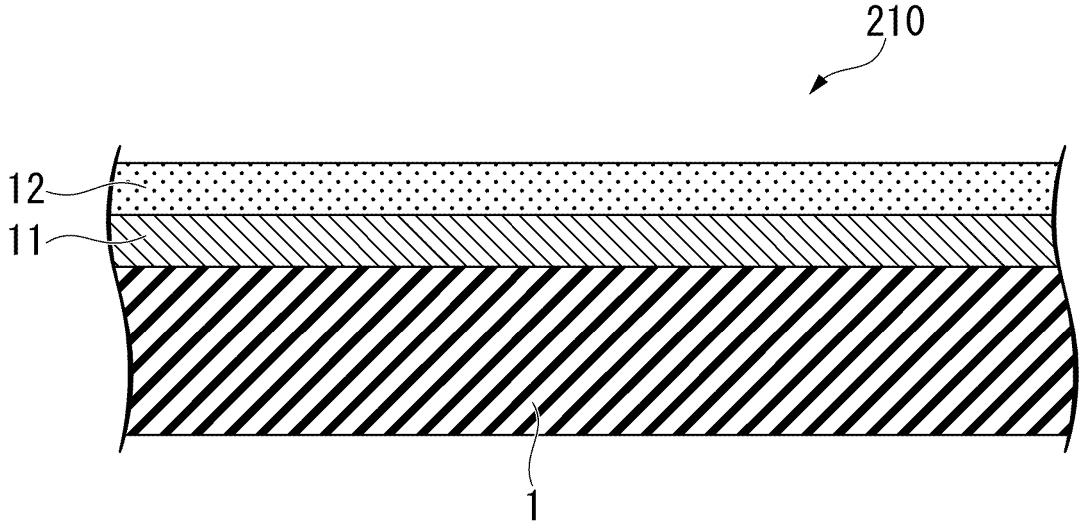


FIG. 7

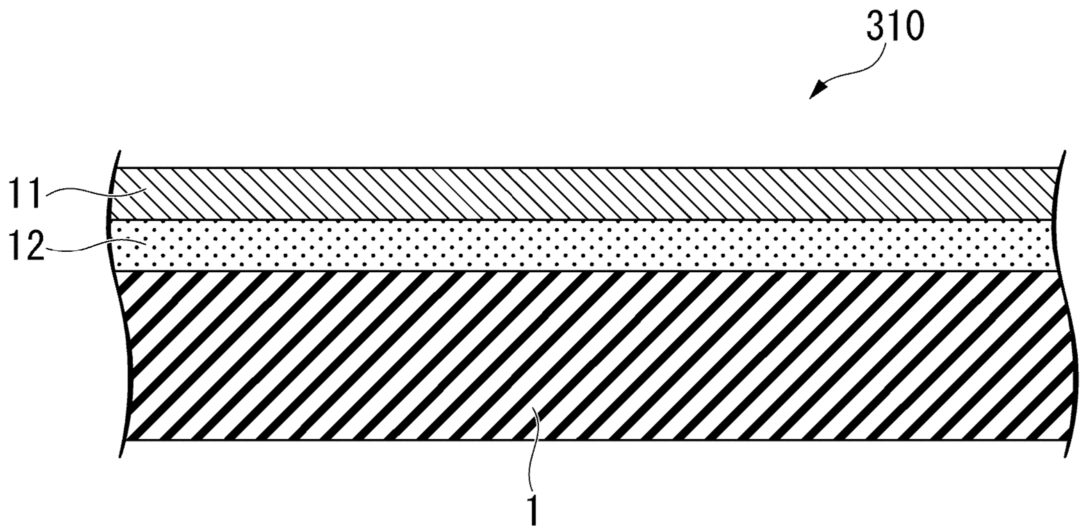

FIG. 8

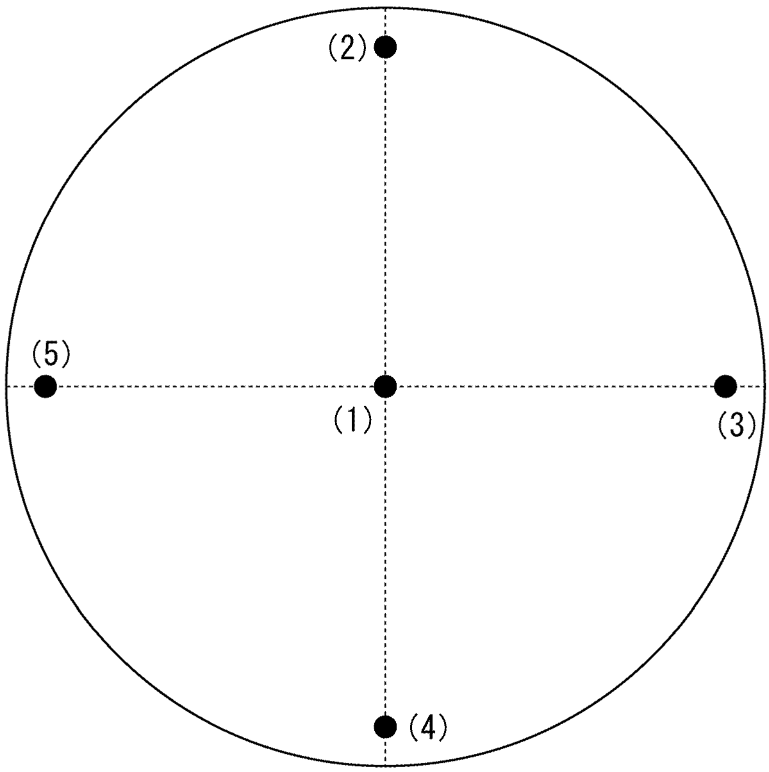

FIG. 9A

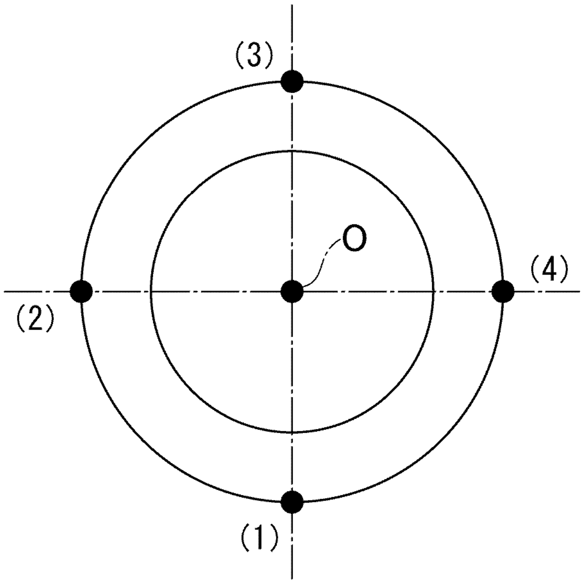


FIG. 9B

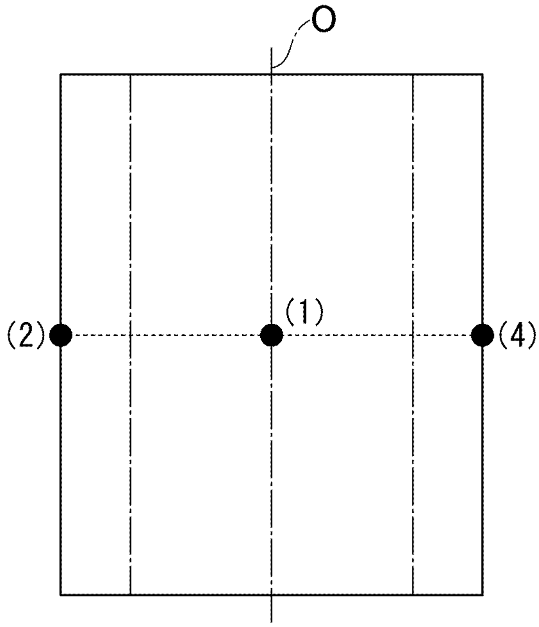

## INTERNATIONAL SEARCH REPORT

International application No.
PCT/JP2019/019612

A. CLASSIFICATION OF SUBJECT MATTER
Int.Cl. C23C14/34(2006.01)i, B32B15/01(2006.01)i, C22C5/06(2006.01)i, C23C14/06(2006.01)i, C23C14/08(2006.01)i, C23C14/14(2006.01)i, H01B5/14(2006.01)i

According to International Patent Classification (IPC) or to both national classification and IPC

B. FIELDS SEARCHED

Minimum documentation searched (classification system followed by classification symbols)
Int.Cl. C23C14/34, B32B15/01, C22C5/06, C23C14/06, C23C14/08, C23C14/14, H01B5/14

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2017-031503 A (MITSUBISHI MATERIALS CORP.) 09 February 2017, paragraphs [0008], [0035], example 1, comparative example 14 & WO 2017/018310 A1 & TW 201718886 A & CN 107709584 A & KR 10-2018-0034334 A | 1,4-7<br>2-3,8-9 |
| A | JP 2003-160860 A (MITSUBISHI MATERIALS CORP.) 06 June 2003, table 1, targets 6-9 of the present invention, comparative example 2 (Family: none) | 1-9 |
| A | JP 2012-007237 A (KOBELCO RESEARCH INSTITUTE, INC.) 12 January 2012 (Family: none) | 1-9 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 30 July 2019 (30.07.2019) | 13 August 2019 (13.08.2019) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2019/019612

C (Continuation). DOCUMENTS CONSIDERED TO BE RELEVANT

| Category* | Citation of document, with indication, where appropriate, of the relevant passages | Relevant to claim No. |
| --- | --- | --- |
| P,X<br>P,A | JP 2018-176493 A (MITSUBISHI MATERIALS CORP.) 15 November 2018, examples 7-8 of the present invention (Family: none) | 7<br>1-6,8-9 |
| P,A | JP 2019-026860 A (MITSUBISHI MATERIALS CORP.) 21 February 2019 (Family: none) | 1-9 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2018095293 A
- JP 2019090548 A
- JP H09291356 B
- JP H10239697 B
- JP 2016040411 A
- JP 2016164305 A